# EUROPÄISCHE PATENTSCHRIFT

(11) **EP 3 947 006 B1**
(45) Veröffentlichungstag und Bekanntmachung des Hinweises auf die Patenterteilung: **02.08.2023**
(21) Anmeldenummer: 20713198.8
(22) Anmeldetag: 11.03.2020
(51) Int. Cl.: B60K 35/00, B60K 37/06, B60H 1/00, G06F 3/0484, H03K 17/96

(54) **VORRICHTUNG UND VERFAHREN ZUR AUSGABE EINES PARAMETERWERTS IN EINEM FAHRZEUG**
DEVICE AND METHOD FOR OUTPUTTING A PARAMETER VALUE IN A VEHICLE
DISPOSITIF ET PROCÉDÉ D'ÉMISSION D'UNE VALEUR DE PARAMÈTRE DANS UN VÉHICULE

(30) Priorität: 25.03.2019 DE 102019204046
(43) Veröffentlichungstag der Anmeldung: 09.02.2022
(73) Patentinhaber: VOLKSWAGEN AKTIENGESELLSCHAFT, 38440 Wolfsburg (DE)
(72) Erfinder: PAPENDIECK, Dirk, 29348 Scharnhorst (Eschede) (DE); JUNGEBLUT, Oliver, 38518 Gifhorn (DE)
(86) Internationale Anmeldenummer: PCT/EP2020/056533
(87) Internationale Veröffentlichungsnummer: WO 2020/193140

(56) Entgegenhaltungen:
- DE-A1-102004 054 269
- US-A1- 2013 128 587
- US-B2- 9 855 845

## Beschreibung

Vorrichtung und Verfahren zur Ausgabe eines Parameterwerts in einem Fahrzeug Die vorliegende Erfindung betrifft eine Vorrichtung und ein Verfahren zur Ausgabe eines Parameterwerts in einem Fahrzeug.

In modernen Fahrzeugen, insbesondere Kraftfahrzeugen, ist eine Vielzahl von elektronischen Einrichtungen vorgesehen, deren Einstellung und Bedienung dem Fahrer oder einem anderen Fahrzeuginsassen ermöglicht werden muss. Zu diesen Einrichtungen gehört beispielsweise eine Klimatisierungseinheit, durch die Luft in bestimmte Bereiche des Fahrzeuginnenraums geleitet werden kann und mittels derer auch weitere Elemente wie zum Beispiel Sitzheizungen gesteuert werden können. Andere Einrichtungen sind etwa ein Navigationssystem, Fahrerassistenzsysteme sowie Kommunikations- und Multimediaeinheiten, etwa eine Telefonanlage oder Einrichtungen zur Wiedergabe von Musik und Sprache wie beispielsweise ein Radio oder ein CD-Spieler.

Zur Bedienung sind unterschiedliche Bedieneinheiten bekannt. Typischerweise steht der Fahrer jedoch vor der Herausforderung, teils sehr komplexe Einrichtungen bedienen zu müssen. Er muss einen Teil seiner Aufmerksamkeit dafür aufwenden, eine Vielzahl von Bedienelementen zu erfassen und so zu bedienen, dass die Einstellungen in der gewünschten Weise vorgenommen oder verändert werden. Dies erfordert häufig das Durchführen von sehr präzisen Bedienhandlungen, wobei der Fahrer allerdings seinen Blick nur sehr kurzfristig vom Verkehrsgeschehen abwenden darf. Dabei sollen Fehlbedienungen vermieden werden, die den Fahrkomfort erheblich beeinträchtigen können und weitere Bedienhandlungen nötig machen. Zugleich müssen eingestellte Parameter für den Nutzer leicht erfassbar sein, um beurteilen zu können, ob ein aktuell eingestellten Parameterwert verändert werden soll oder ob geeignete Einstellungen beibehalten werden können.

Aus der DE 10 2016 200 110 A1 ist eine Vorrichtung zur Bedienung eines Heiz-Klima-Systems eines Fortbewegungsmittels bekannt, bei dem in einer im Wesentlichen ebenen Oberfläche eine Fingerrinne ausgebildet ist, in der ausgeführte Wischgesten erfasst werden können. Eine Vorrichtung mit den Merkmalen des Oberbegriffs des Anspruchs 1 ist aus der DE102004054269 A1 bekannt. Die US2013128587 A1 zeigt eine weitere Vorrichtung des Stands der Technik.

Bei bekannten Vorrichtungen zum Anzeigen eines Parameterwerts treten häufig Streueffekte innerhalb der Anzeige auf, die als störend empfunden werden und das Erfassen des angezeigten Wertes erschweren.

Der vorliegenden Erfindung liegt die Aufgabe zugrunde, eine Vorrichtung und ein Verfahren der eingangs genannten Art bereitzustellen, bei denen ein Parameter besonders deutlich und leicht erfassbar ausgegeben werden kann.

Erfindungsgemäß wird diese Aufgabe durch eine Vorrichtung mit den Merkmalen des Anspruchs 1 und ein Verfahren mit den Merkmalen des Anspruchs 10 gelöst. Vorteilhafte Ausgestaltungen und Weiterbildungen ergeben sich aus den abhängigen Ansprüchen.

Die erfindungsgemäße Vorrichtung zur Ausgabe eines Parameterwerts in einem Fahrzeug umfasst zumindest zwei Leuchtelemente, nämlich ein erstes und ein zweites Leuchtelement. Dabei ist für jedes der zumindest zwei Leuchtelemente zumindest ein Grund-Aktivierungszustand und ein Anzeige-Aktivierungszustand aktivierbar. Dabei emittieren die Leuchtelemente bei dem Grund-Aktivierungszustand Licht einer Grundintensität und bei dem Anzeige-Aktivierungszustand Licht einer Anzeige-Intensität, wobei die Anzeige-Intensität höher ist als die Grundintensität. Die Vorrichtung umfasst ferner eine Steuereinheit, die dazu eingerichtet ist, für die zumindest zwei Leuchtelemente entweder den Grund-Aktivierungszustand oder den Anzeige-Aktivierungszustand so zu aktivieren, dass der Parameterwert ausgegeben wird.

Dadurch kann vorteilhafterweise vermieden werden, dass durch Streuung oder andere optische Effekte ein "Überleuchten" von einem Leuchtelement zu einem anderen wahrnehmbar ist.

Die Leuchtelemente können auf an sich bekannte Weise ausgebildet sein. Sie umfassen eine Lichtquelle, die beispielsweise als Leuchtdiode (englisch: "*light emitting diode*"*,* LED) ausgebildet ist. Insbesondere ist für jedes Leuchtelement eine eigene Lichtquelle vorgesehen. Typischerweise wird das Licht der Lichtquelle durch einen Lichtschacht zu einer Leuchtfläche geleitet und letztere dadurch beleuchtet. Die bekannten Methoden, ein Überleuchten von einer Leuchtfläche zur anderen zu vermeiden, sind entweder in ihrer Wirkung ungenügend oder mit hohem Aufwand und entsprechenden Kosten verbunden. Das Überleuchten führt jedoch dazu, dass eine unbeleuchtete Leuchtfläche in der Nähe einer anderen, beleuchteten Leuchtfläche Licht einer geringeren Intensität emittiert. Dies kann dazu führen, dass ein Gradient wahrnehmbar ist, der von helleren zu dunkleren Leuchtflächen verläuft. Dies lässt die Anzeige unscharf erscheinen und führt zu einer erschwerten Ablesbarkeit.

Bei dem Verfahren der Erfindung wird dieser Effekt dadurch kaschiert, dass sämtliche Leuchtelemente der Vorrichtung zumindest mit einer Grundintensität beleuchtet werden. Diese ist so gewählt, dass ein ausreichender Kontrast zu der Anzeige-Intensität hergestellt wird und dass das Überleuchten im Bereich eines nicht mit der Anzeige-Intensität beleuchteten Leuchtelements im Wesentlichen nicht mehr erkennbar ist. Insbesondere unterscheidet sich die Grundintensität zumindest von einem Zustand, bei dem ein Leuchtelement deaktiviert ist und kein Licht emittiert, durch eine schwache Beleuchtung.

Bei einer weiteren Ausbildung weist das im Grund-Aktivierungszustand emittierte Licht eine Farbe auf, die von der Farbe des im Anzeige-Aktivierungszustand emittierten Lichts verschieden ist.

Bei einer Ausbildung der erfindungsgemäßen Vorrichtung ist die Steuereinheit dazu eingerichtet, den Anzeige-Aktivierungszustand für umso mehr Leuchtelemente zu aktivieren, je höher der Parameterwert ist, und für die verbleibenden Leuchtelemente den Grund-Aktivierungszustand zu aktivieren. Der Parameterwert ist dadurch vorteilhafterweise einfach und intuitiv ablesbar.

Bei der Vorrichtung wird die Gesamtzahl der Leuchtelemente so angesteuert, dass alle Leuchtelemente entweder in dem Grund-Aktivierungszustand oder in dem Anzeige-Aktivierungszustand sind. Insbesondere ist kein weiterer Zustand vorgesehen. Das heißt, bei dieser Ausbildung wird zunächst anhand des aktuellen Parameterwerts bestimmt, für welche Leuchtelemente der Anzeige-Aktivierungszustand aktiviert werden soll; dies definiert dadurch auch, für welche verbleibenden Leuchtelemente der Grund-Aktivierungszustand aktiviert wird.

Bei einem weiteren Ausführungsbeispiel kann der Anzeige-Aktivierungszustand mehrere Teilzustände umfassen, bei denen Licht mit unterschiedlicher Intensität emittiert wird, beispielsweise um Bruchteile von Parameterwerten anzuzeigen. Die in diesen Teilzuständen emittierten Anzeige-Intensitäten sind jedoch ebenfalls größer als die Grundintensität.

Bei einer weiteren Ausbildung sind die Leuchtelemente aneinander angrenzend angeordnet. Dadurch kann der Parameterwert vorteilhafterweise besonders deutlich ausgegeben werden. Insbesondere sind die Leuchtsegmente von einer Segmentanzeige umfasst und die Leuchtsegmente geben den Parameterwert nach Art einer an sich bekannten Segmentanzeige aus. Insbesondere ist dabei die Anzahl der Leuchtelemente im Anzeige-Aktivierungszustand proportional, zum Beispiel direkt proportional, zu dem Betrag des Parameterwertes. Der Parameterwert kann dadurch vorteilhafterweise besonders einfach und schnell abgelesen werden.

Bei weiteren Ausbildungen sind die Leuchtelemente in einem Abstand zueinander, insbesondere äquidistant, so angeordnet, dass der Abstand klein gegenüber einer Breitenausdehnung der einzelnen Leuchtelemente ist. Die Breitenausdehnung verläuft dabei in die Richtung, in welcher die Leuchtelemente nebeneinander angeordnet sind, wobei die Breitenausdehnung insbesondere für sämtliche Leuchtelemente der Vorrichtung gleich ist. Der Abstand beträgt beispielsweise höchstens die halbe Breitenausdehnung, bevorzugt höchstens ein Viertel der Breitenausdehnung der Leuchtelemente.

Die Leuchtelemente sind insbesondere entlang einer Längserstreckung nebeneinander angeordnet. Sie können dabei beispielsweise entlang einer geraden oder gebogenen Linie angeordnet sein. Dies erlaubt vorteilhafterweise eine flexible Anordnung der Leuchtelemente so, dass die Anzeige an verschiedene Umgebungen angepasst werden kann.

Erfindungsgemäß ist die Steuereinheit dazu eingerichtet, die Grundintensität in Abhängigkeit von der Anzeige-Intensität zu wählen. Dadurch können Grund- und Anzeige-Intensität vorteilhafterweise besonders gut aufeinander abgestimmt und flexibel an verschiedene Anzeigebedingungen angepasst werden.

Insbesondere wird die Grundintensität stets so gebildet, dass das Überleuchten zu benachbarten Leuchtflächen kaschiert wird. Die Grundintensität kann beispielsweise auch ein bestimmter Bruchteil der Anzeige-Intensität sein, wobei das Verhältnis der Intensitäten zueinander fest vorgegeben ist oder in Abhängigkeit von weiteren Faktoren bestimmt werden kann. Insbesondere werden die Anzeige- und Grundintensität in Abhängigkeit von einer Umgebungshelligkeit bestimmt. Beispielsweise ist die Anzeige-Intensität umso höher, je höher die detektierte Umgebungshelligkeit ist; die Grundintensität kann dann entsprechend ebenso höher sein als bei einer geringeren Umgebungshelligkeit.

Bei einer Ausbildung weist die Vorrichtung einen Tagmodus und einen Nachtmodus auf, wobei die Anzeige-Intensität im Tagmodus höher ist als im Nachtmodus. Insbesondere ist auch die Grundintensität im Tagmodus höher als im Nachtmodus. Dadurch wird vorteilhafterweise eine besonders gut sichtbare Ausgabe erzeugt.

Der Tag- und Nachtmodus können beispielsweise anhand einer Uhrzeit oder anhand einer Messung der Helligkeit in der Umgebung des Fahrzeugs aktiviert werden. Dem Tag- und dem Nachtmodus sind insbesondere verschiedene Werte der Grund- und Anzeige-Intensität zugeordnet. Zudem kann die Grundintensität in Abhängigkeit von der zugeordneten Anzeige-Intensität bestimmt werden. Ferner können die Grund- und Anzeige-Intensität im Tag- und Nachtmodus in verschiedenen Verhältnissen zueinander stehen, etwa indem die Grundintensität im Tagmodus als größerer oder kleinerer Bruchteil der Anzeige-Intensität gebildet ist.

Die Grund- und Anzeige-Intensität können ferner in einem Verfahren gewählt werden, bei dem zunächst die Anzeige-Intensität, beispielsweise anhand einer Umgebungshelligkeit, und anschließend anhand der Anzeige-Intensität auch die Grundintensität bestimmt wird. Hierfür kann eine Vielzahl von Wertepaaren für die Anzeige- und Rundintensität vorbestimmt sein oder es kann ein physikalisches Modell verwendet werden, anhand dessen die erforderliche Grundintensität zum Kaschieren des Überleuchtens bei einer bestimmten Anzeige-Intensität berechnet wird.

Bei einer weiteren Ausbildung weist jedes der Leuchtelemente ferner einen Dunkelzustand auf, bei dem es im Wesentlichen kein Licht emittiert. Insbesondere sind sämtliche Leuchtelemente gleichzeitig im Dunkelzustand, wenn die Anzeige durch die Vorrichtung deaktiviert ist. Dadurch wird vorteilhafterweise zwischen drei verschiedenen Zuständen der Leuchtelemente unterschieden und die Anzeige kann besonders gut erfassbar ausgebildet sein.

Insbesondere ist der Dunkelzustand der Leuchtelemente nur dann aktiv, wenn die Vorrichtung deaktiviert ist beziehungsweise wenn kein Parameterwert ausgegeben wird. Das heißt, sobald ein Parameterwert ausgegeben werden soll, befinden sich sämtliche Leuchtelemente entweder im Grund- oder Anzeige-Aktivierungszustand.

Insbesondere ist die Grundintensität höher als eine eventuelle Restemission der Leuchtelemente im Dunkelzustand.

Bei einer Weiterbildung weist die Vorrichtung ferner eine Abdeckschicht auf, die so gebildet ist, dass die Leuchtelemente im Dunkelzustand für einen Betrachter der Vorrichtung nicht sichtbar sind. Insbesondere wird dabei ein sogenanntes "*Black Panel*" verwendet. Insbesondere sind ferner Leuchtelemente sichtbar, wenn sie Licht der Grundintensität emittieren. Der Nutzer kann dadurch besonders leicht erkennen, dass die Vorrichtung aktiv ist, sobald die Leuchtelemente beleuchtet werden.

Insbesondere ist in dem Bereich der Leuchtelemente, wenn diese im Dunkelzustand sind, eine Oberfläche ausgebildet, die für den Nutzer durchgehend schwarz und gegebenenfalls mit permanent sichtbaren Aufdrucken oder Prägungen erscheint.

Bei einer Ausbildung umfasst die Vorrichtung ferner eine Erfassungseinheit, durch die mittels einer berührungsempfindlichen Oberfläche im Bereich der Leuchtelemente der Parameterwert erfassbar ist. Insbesondere wird hierdurch ein von den Leuchtelementen beleuchtetes Bedienelement oder eine Bedienfläche gebildet. Dadurch kann die Anzeige vorteilhafterweise mit einer Erfassung der Eingabe kombiniert werden, insbesondere einer Erfassung des ausgegebenen Parameterwerts.

In dem Bereich der Leuchtelemente kann die berührungsempfindliche Oberfläche beispielsweise als Schaltfläche oder als Schieberegler beziehungsweise sogenannter "*Slider*" ausgebildet sein. Bei dem Verfahren kann die Beleuchtung mit der Grundintensität dazu dienen, die Position der berührungsempfindlichen Oberfläche und der bedienbaren Elemente anzuzeigen sowie Aufschluss über deren Bedienbarkeit auszugeben.

Dabei ist die Erfassung von Betätigungen, etwa anhand von Gesten, nicht notwendigerweise auf eine Oberfläche beschränkt. Gesten können vielmehr in einem praktisch beliebig gebildeten Erfassungsbereich durchgeführt und gegebenenfalls mit verschiedenen Erfassungsverfahren erfasst werden. Beispielsweise kann eine Geste auch im dreidimensionalen Raum erfasst werden. Insbesondere kann ein virtuelles Bedienobjekt, etwa ein virtueller Taster, ausgebildet sein. Zum Beispiel kann die Geste in einem Raumbereich erfasst werden, in dem das virtuelle Bedienobjekt etwa mittels einer Projektion oder durch Verfahren der virtuellen Realität erzeugt wird und eine Geste wird mit Bezug zu diesem virtuellen Bedienobjekt erfasst. Insbesondere werden hierzu eine Position, eine Gestentrajektorie, eine Richtung und/oder eine Geschwindigkeit einer Geste erfasst.

Bei einer weiteren Ausbildung weist die Vorrichtung im Bereich der berührungsempfindlichen Oberfläche eine Oberflächenstrukturierung auf, insbesondere eine Vertiefung oder Erhöhung.

Dadurch können bedienbare Bereiche vorteilhafterweise besonders leicht gefunden und bedient werden.

Insbesondere wird auf diese Weise eine Fühlhilfe bereitgestellt, anhand derer der Nutzer die Position und Erstreckung der Erfassungsbereiche erfassen kann. Beispielsweise kann eine taktil erfassbare Oberflächendeformation eine lokal veränderte Rauigkeit umfassen. Ferner kann an der Oberfläche eine im Wesentlichen punktförmige Erhöhung oder Vertiefung ausgebildet sein oder es kann eine längliche Vertiefung oder Erhöhung vorgesehen sein. Ferner sind komplexere Formen denkbar, etwa eine Vertiefung mit einem darin verlaufenden Grat oder weitere fühlbare Markierungen. Eine Vertiefung kann ferner geradlinig verlaufen oder entlang einer gekrümmten Linie.

Bei einer weiteren Ausbildung umfasst die Vorrichtung ferner einen Sensor zum Erfassen einer Annäherung an die berührungsempfindliche Oberfläche auf an sich bekannte Weise. Wenn eine solche Annäherung erfasst wird, können die Leuchtelemente so angesteuert werden, dass sie zumindest Licht der Grundintensität emittieren, um somit beispielsweise einem Nutzer die Position der Leuchtelemente anzuzeigen oder auf eine Eingabemöglichkeit hinzuweisen.

Insbesondere betrifft der Parameterwert eine Einstellung einer Temperatur, eines Gebläses oder einer Medienwiedergabeeinrichtung des Fahrzeugs.

Bei dem erfindungsgemäßen Verfahren zur Ausgabe eines Parameterwerts in einem Fahrzeug wird für zumindest zwei Leuchtelemente entweder ein Grund-Aktivierungszustand oder ein Anzeige-Aktivierungszustand so aktiviert, dass der Parameterwert ausgegeben wird. Dabei emittieren die Leuchtelemente bei dem Grund-Aktivierungszustand Licht einer Grundintensität und bei dem Anzeige-Aktivierungszustand Licht einer Anzeige-Intensität, wobei die Anzeige-Intensität höher ist als die Grundintensität.

Das erfindungsgemäße Verfahren ist insbesondere ausgebildet, die vorstehend beschriebene erfindungsgemäße Vorrichtung zu betreiben. Das Verfahren weist somit dieselben Vorteile auf wie die erfindungsgemäße Vorrichtung.

Die Erfindung wird nun anhand von Ausführungsbeispielen mit Bezug zu den Zeichnungen erläutert.
- Figur 1: zeigt ein Fahrzeug mit einem Ausführungsbeispiel der erfindungsgemäßen Vorrichtung,
- Figur 2: zeigt weitere Details des Ausführungsbeispiels der erfindungsgemäßen Vorrichtung,
- Figuren 3A bis 3C: zeigen ein Ausführungsbeispiel einer Ausgabe eines Parameterwerts mittels einer Segmentanzeige,
- Figuren 4A und 4B: zeigen ein Ausführungsbeispiel für die Einstellung von Parameterwerten mittels eines Slider-Elements,
- Figuren 5A bis 5F: zeigen ein Ausführungsbeispiel für die Einstellung einer Luftverteilung durch ein Gebläse und
- Figuren 6A bis 6C: zeigen ein weiteres Ausführungsbeispiel für die Einstellung eines Parameterwerts mittels eines Slider-Elements.

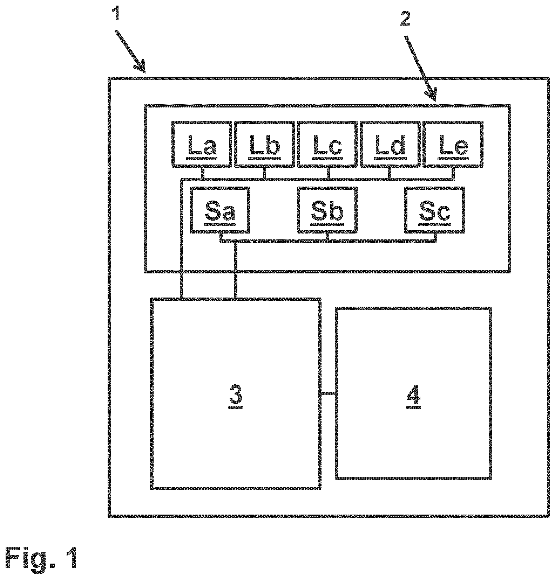

Mit Bezug zu Figur 1 wird ein Fahrzeug mit einem Ausführungsbeispiel der Vorrichtung erläutert.

Ein Fahrzeug 1 umfasst eine Erfassungseinheit 2, die mit einer Steuereinheit 3 gekoppelt ist. Mit der Steuereinheit 3 ist ferner eine Klimatisierungseinheit 4 gekoppelt.

Bei dem Ausführungsbeispiel weist die Erfassungseinheit 2 eine einem Nutzer im Fahrzeug 1 zugewandte Oberfläche auf. Auf dieser Oberfläche sind unterschiedliche Symbole angeordnet, die teilweise durch Lichtquellen, insbesondere LEDs, hinterleuchtet werden können. Es sind ferner Bereiche mit Leuchtflächen ausgebildet, die von einer Farbschicht so bedeckt sind, dass die Leuchtflächen für den Nutzer im Wesentlichen nur dann sichtbar sind, wenn diese tatsächlich beleuchtet werden, während sie praktisch unsichtbar sind, wenn die Leuchtflächen nicht beleuchtet werden. Dabei wird insbesondere eine als sogenanntes *Black Panel* ausgebildete Anzeige verwendet.

Die Oberfläche der Erfassungseinheit 2 kann eben ausgebildet sein. Sie kann ferner Vertiefungen und/oder Erhöhungen aufweisen, die für einen Nutzer mit dem Finger erfassbar sind und als Fühlhilfen dazu dienen können, bestimmte Bereiche der Oberfläche besonders zu kennzeichnen. Beispielsweise können solche Füllhilfen einen mechanischen Schalter oder einen berührungsempfindlichen Bereich der Oberfläche hervorheben, der beispielsweise als Taster-Element oder als Slider-Element ausgebildet ist.

Die Erfassungseinheit 2 umfasst ferner eine im IML-Verfahren (*in-mould labeling*) hergestellte und mit Kunststoff hinterspritzte Folie. Sie umfasst bei dem Ausführungsbeispiel zudem Sensorelemente Sa, Sb, Sc, die hier als kapazitive Sensorelemente ausgebildet sind. Die Sensorelemente Sa bis Sc sind so hinter der Oberfläche der Erfassungseinheit 2 angeordnet, dass sie für den Nutzer nicht sichtbar sind. Die Sensorelemente Sa bis Sc sind auf an sich bekannte Weise so ausgebildet, dass sie eine Betätigung durch ein Betätigungselement erfassen können. Sie weisen hierzu jeweils einen Erfassungsbereich auf, der beispielsweise einen Bereich der Oberfläche der Erfassungseinheit 2 und/oder einen über der Oberfläche angeordneten räumlichen Bereich umfasst. Insbesondere kann ein Finger des Nutzers als Betätigungselement verwendet werden. Bei dem Ausführungsbeispiel erfassen die Sensorelemente Sa bis Sc eine Betätigung anhand des Eintretens des Betätigungselement in den Erfassungsbereich, anhand eines Berührung einer Fläche, anhand seines Abstands zu einem Sensorelement Sa bis Sc, anhand einer Bewegung im Erfassungsbereich und/oder anhand einer Zeitdauer, während welcher das Betätigungselement detektiert wird. Diese Betätigung wird anschließend durch die Erfassungseinheit 2 und/oder die Steuereinheit 3 ausgewertet.

Bei dem Ausführungsbeispiel sind die Sensorelemente Sa bis Sc entlang einer geraden Linie äquidistant zueinander angeordnet. Entlang dieser Linie wird dadurch ein Schieber- oder Slider-Element implementiert. Dessen Funktion wird weiter unten im Detail erläutert.

Bei weiteren Ausführungsbeispielen weist die Erfassungseinheit 2 alternativ oder zusätzlich auf andere, an sich bekannte Weise ausgebildete berührungsempfindliche Oberflächenbereiche auf. Durch diese kann eine Betätigung durch ein Betätigungselement analog zu der oben erläuterten Funktionsweise der Sensorelemente Sa bis Sc erfasst werden.

Insbesondere erzeugt die Erfassungseinheit 2, wenn eine Betätigung detektiert wird, ein Steuersignal und überträgt dieses an die Steuereinheit 3. Es kann ein Parameterwert eingestellt werden, wobei entweder die Erfassungseinheit 2 selbst die Eingabe bereits so weit verarbeitet, dass sie ihr einen konkreten Parameterwert zuordnet, oder die Steuereinheit 3 diese Verarbeitung des von der Erfassungseinheit 2 erzeugten Eingabe- oder Steuersignals übernimmt.

Ferner umfasst die Erfassungseinheit 2 Leuchtelemente La, Lb, Lc, Ld, Le, die in Form einer Segmentanzeige aneinander angrenzend entlang einer linearen Erstreckungsrichtung angeordnet sind. Die Leuchtelemente La bis Le sind unabhängig voneinander durch die Steuereinheit 3 ansteuerbar.

Die Klimatisierungseinheit 4 ist auf an sich bekannte Weise gebildet und umfasst bei dem Ausführungsbeispiel unter anderem eine Heizung für das Fahrzeug 1, Sitzheizungen für den Fahrer- und Beifahrersitz, eine Lenkradheizung, Scheibenheizungen sowie ein Gebläse zum Einleiten von Luft in den Innenraum des Fahrzeugs 1, wobei die Richtung, Verteilung, Intensität und Temperatur der einströmenden Luft eingestellt werden kann.

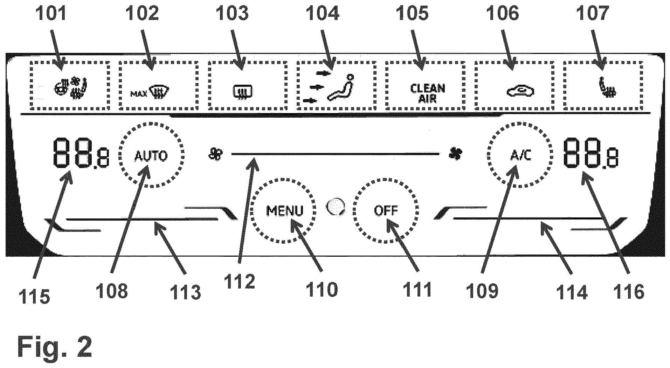

Mit Bezug zu Figur 2 wird das oben mit Bezug zu Figur 1 erläuterte Ausführungsbeispiel der Vorrichtung genauer erläutert.

Figur 2 zeigt eine Ansicht der dem Nutzer im Innenraum des Fahrzeugs 1 zugewandten Oberfläche der Erfassungseinheit 2. Diese Oberfläche ist im Wesentlichen als horizontal gestrecktes Rechteck ausgebildet. Im oberen Bereich sind nebeneinander Taster-Elemente 101, 102, 103, 104, 105, 106, 107 angeordnet. Diese sind bei dem Ausführungsbeispiel als berührungsempfindliche Oberflächenbereiche ausgebildet, die durch Berühren mit einem Betätigungselement, insbesondere einem Finger des Nutzers, betätigt werden können. In Figur 2 sind die den einzelnen Taster-Elementen 101 bis 107 zugeordneten berührungsempfindlichen Bereiche durch gestrichelte Linien angedeutet. Innerhalb dieser Bereiche sind ferner Leuchtflächen ausgebildet, die durch Aktivieren einer dahinter angeordneten LED mit Licht einer bestimmten Intensität und/oder Farbe beleuchtet werden können, etwa um den Status, die Aktivität oder eine Einstellung einer dem jeweiligen Taster-Element 101 bis 107 zugeordneten Funktion auszugeben. Die Ansteuerung der Erfassungseinheit 2 und gegebenenfalls die Auswertung von durch die Erfassungseinheit 2 erfassten Signale erfolgt durch die Steuereinheit 3.

In einem mittleren und unteren Bereich der Oberfläche der Erfassungseinheit 2 sind zudem weitere Taster-Elemente 108, 109, 110, 111 ausgebildet. Auch diese sind bei dem Ausführungsbeispiel mittels berührungsempfindlicher Oberflächenbereiche ausgebildet, die durch gestrichelte Linien angedeutet sind. Durch Betätigen der weiteren Taster-Elemente 108 bis 111 können weitere Funktionen aufgerufen, aktiviert oder eingestellt werden. So kann beispielsweise durch Betätigen des Taster-Elements 110 "MENU" eine Menüdarstellung auf einem Display im Fahrzeug 1 aufgerufen werden. Durch Betätigen des Taster-Elements 111 "OFF" kann die Klimatisierungseinheit 4 ausgeschaltet werden. Mittels des Taster-Elements 109 "A/C" kann die Klimaanlage der Klimatisierungseinheit 4 des Fahrzeugs 1 aktiviert, mittels des Taster-Elements 108 "AUTO" kann ein automatischer Modus der Klimatisierungseinheit 4 aktiviert werden.

Bei anderen Ausführungsbeispielen können die Taster-Element 101 bis 111 als mechanische Schalter, insbesondere Tastschalter, ausgebildet sein. Zudem können bei weiteren Ausführungsbeispielen andere Funktionen alternativ oder zusätzlich vorgesehen sein.

Im mittleren und unteren Bereich der Oberfläche der Erfassungseinheit 2 sind ferner Segmentanzeigen 115, 116 angeordnet, die bei dem Ausführungsbeispiel zur Ausgabe eines zweistelligen Temperaturwerts mit einer Nachkommastelle geeignet sind. Ferner sind hier Slider-Elemente 112, 113, 114 zum Einstellen einer Temperatur und einer Gebläsestufe angeordnet. Die jeweils einstellbaren Funktionen der Klimatisierungseinheit 4 werden durch Symbole auf der Oberfläche angedeutet. Die Slider-Elemente 112 bis 114 umfassen jeweils eine horizontale gerade Linie einer bestimmten Länge, entlang derer eine Vertiefung auf der Oberfläche der Erfassungseinheit 2 ausgebildet ist. Dahinter verdeckt durch die Oberfläche sind Sensorelemente Sa bis Sc angedeutet, durch die jeweils eine Berührung im Bereich eines Slider-Elements 112 bis 114 detektierbar ist, wobei insbesondere eine Position der Berührung sowie gegebenenfalls eine Bewegung entlang des Slider-Elements 112 bis 114 erfasst wird.

Bei dem Ausführungsbeispiel ist die Linie des Slider-Elements 112 zum Einstellen des Gebläses, das heißt der Gebläse-Slider 112, durch dahinter angeordnete Leuchtelemente La bis Le segmentweise beleuchtbar.

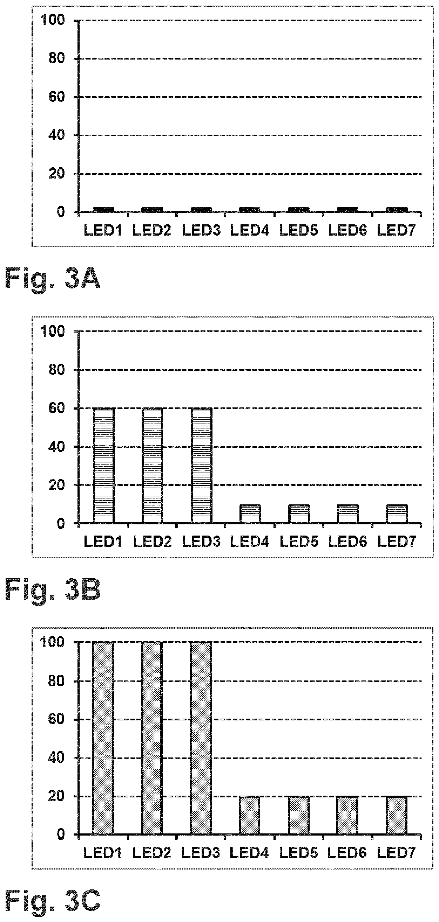

Mit Bezug zu den Figuren 3A bis 3C wird ein Ausführungsbeispiel einer Ausgabe einer eingestellten Stufe eines Gebläses der Klimatisierungseinheit 4 mittels einer Segmentanzeige erläutert. Dabei wird insbesondere von dem oben mit Bezug zu den Figuren 1 und 2 erläuterten Ausführungsbeispiel der Vorrichtung ausgegangen. Die Segmentanzeige des Ausführungsbeispiels ist insbesondere im Bereich des Gebläse-Sliders 112 angeordnet und die Ansteuerung erfolgt durch die Steuereinheit 3.

Bei dem Beispiel sind sieben Leuchtflächen LED1 bis LED7, insbesondere beleuchtbar durch LEDs, entlang einer geraden Linie nebeneinander angeordnet und unabhängig voneinander ansteuerbar. Die Anzahl leuchtender Leuchtflächen LED1 bis LED7 entspricht der aktivierten Stufe des Gebläses, das heißt, es sind so viele Stufen wie Leuchtflächen LED1 bis LED7 vorgesehen. Bei dem Ausführungsbeispiel ist ferner eine Streuscheibe über den Leuchtflächen LED1 bis LED7 angeordnet, sodass nebeneinander angeordnete beleuchtete Leuchtflächen LED1 bis LED7 aus der Perspektive des Nutzers eine durchgehende Linie zu bilden scheinen.

Bei dem in Figur 3A gezeigten Fall ist das Gebläse der Klimatisierungseinheit 4 deaktiviert. Der Graph zeigt die Intensität der Lichtemission auf der Y-Achse, während die einzelnen Leuchtflächen LED1 bis LED7 Positionen entlang der X-Achse zugeordnet sind. Keine der Leuchtflächen leuchtet, was in dem Diagramm der Figur 3A durch praktisch nicht sichtbare Säulen dargestellt ist.

Bei den Fällen der Figuren 3B und 3C ist die dritte Stufe des Gebläses der Klimatisierungseinheit 4 aktiviert. Die Graphen zeigen die Intensität des von den Leuchtflächen LED1 bis LED7 emittierten Lichts in Abhängigkeit von der Position beziehungsweise von der jeweiligen Leuchtfläche LED1 bis LED7. Bei dem Fall der Figur 3B ist ein Nachtmodus, bei dem Fall der Figur 3C ein Tagmodus der Segmentanzeige aktiviert. Die ersten drei Leuchtflächen werden so angesteuert, dass sie mit 60 % beziehungsweise 100 % einer maximalen Intensität leuchten, während die restlichen vier Leuchtflächen so angesteuert werden, dass sie mit lediglich 10 % beziehungsweise 20 % der maximalen Intensität leuchten. Das heißt, im Tagmodus erfolgt die Anzeige mittels einer gegenüber dem Nachtmodus erhöhten Lichtintensität, um auch bei starkem Umgebungslicht tagsüber die Anzeige problemlos ablesbar zu gestalten, ohne jedoch bei geringem Umgebungslicht in der Nacht den Nutzer eine zu hohe Intensität zu stören oder zu blenden.

Bei dem Ausführungsbeispiel wird ein "Überleuchten" von einer hell beleuchteten Leuchtfläche zu einer benachbarten, nicht oder schwächer beleuchteten Leuchtfläche kaschiert, indem alle Leuchtflächen zumindest mit einer Grundintensität beleuchtet werden. Lediglich die eigentlich zur Anzeige verwendeten Leuchtflächen werden mit einer höheren Anzeige-Intensität beleuchtet. Das heißt, alle nicht der Anzeige der Gebläsestufe dienenden Leuchtflächen werden gleichmäßig beleuchtet, statt durch das Überleuchten unterschiedliche Intensitäten aufzuweisen, je nach dem Abstand von einer mit höherer Intensität beleuchteten Leuchtfläche.

Um diese gleichmäßige Beleuchtung mit der Grundintensität zu erreichen, kann es nötig sein, die LEDs mit unterschiedlichem Strom zu beaufschlagen; insbesondere wird so ein Überleuchten kompensiert. Beispielsweise kann bei dem in Figur 3B gezeigten Fall vorgesehen sein, dass die ersten drei LEDs LED1, LED2, LED3 mit einem ersten Strom für 60 % der Maximalintensität betrieben werden, wobei ein Überleuchten dazu führt, dass im Bereich der beiden benachbarten Leuchtflächen LED4 und LED5 bereits eine gewisse Intensität emittiert wird. Die LEDs dieser Leuchtflächen LED4 und LED5 werden daher nur mit geringerem Strom betrieben als die LEDs weiter entfernt positionierter Leuchtflächen LED6 und LED7, um eine gleichmäßige Grundintensität der LEDs LED4 bis LED7 zu erreichen. Zum Beispiel wird die direkt benachbarte Leuchtfläche LED4 mit 5 % und die weitere benachbarte Leuchtfläche LED5 mit 7 % betrieben, während die weiter entfernten Leuchtflächen LED6 und LED7 mit 10 % betrieben werden. In weiteren Ausführungsbeispielen können andere Lichtquellen, die insbesondere Licht in die Leuchtflächen LED1 bis LED7, berücksichtigt und durch eine geeignete Ansteuerung der LEDs kompensiert.

Bei weiteren Ausführungsbeispielen können andere Verhältnisse zwischen den Intensitäten sowie verschiedene Modi vorgesehen sein. Beispielsweise kann eine Umgebungshelligkeit erfasst und die Lichtintensität der aktivierten Leuchtflächen dynamisch an die erfasste Umgebungshelligkeit angepasst werden. Ferner können einander zugeordnete Werte von Grundintensität und Anzeige-Intensität fest vorbestimmt sein, wie es bei dem Ausführungsbeispiel der Fall ist. Ferner kann die Grundintensität beispielsweise ein bestimmter Bruchteil der Anzeige-Intensität sein oder die Grundintensität kann auf andere Weise ermittelt werden, etwa anhand eines physikalischen Modells, bei dem die Intensität eines Überleuchtens in Abhängigkeit von der Anzeige-Intensität bestimmt wird und anschließend eine Grundintensität so gebildet wird, dass das Überleuchten hierdurch kaschiert wird.

Bei einem weiteren Ausführungsbeispiel werden auch bei deaktiviertem Gebläse sämtliche Leuchtflächen mit einer Grundintensität beleuchtet, die etwa anhand einer Umgebungshelligkeit bestimmt wird. Auf diese Weise können die Leuchtflächen als Designelemente sowie zur Anzeige einer Stufe "0" genutzt werden. Der Nutzer kann dann insbesondere erkennen, dass sich in einem bestimmten Bereich eine Anzeige für die Einstellung des Gebläses befindet und/oder dass in einem solchen Bereich eine Bedienung zum Einstellen des Gebläses vorgenommen werden kann.

Bei weiteren Ausführungsbeispielen können die Leuchtflächen zum Anzeigen eines anderen Parameters genutzt werden. Sie können ferner im Zusammenhang mit verschiedenen Slider-Elementen 112, 113, 114 oder anderen Anzeigen verwendet und in der beschriebenen Weise angesteuert werden.

Ferner kann eine höhere Anzahl von Leuchtflächen verwendet werden, insbesondere mehr Leuchtflächen als Stufen einstellbar sind. Beispielsweise können auf diese Weise Zwischenstufen angezeigt werden oder während einer Bedienung, beispielsweise mittels des Gebläse-Sliders 112, können die beleuchteten Leuchtflächen der Position des Betätigungsobjekts auf dem Slider 112 folgen. Sie können ferner statt einer linearen Anordnung nebeneinander auf andere Weise angeordnet sein, etwa in einer zweidimensionalen Matrix.

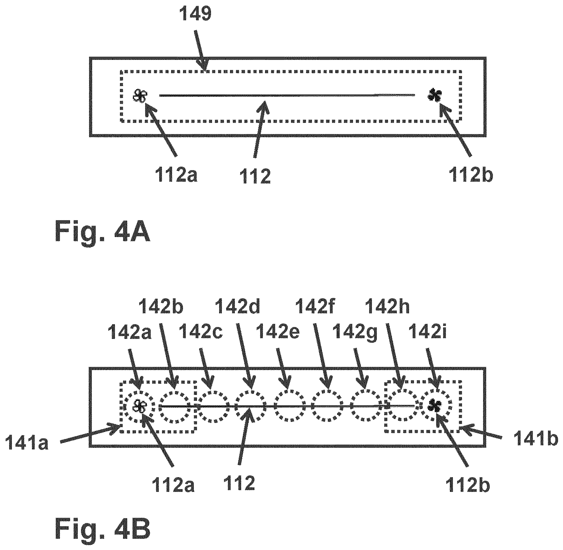

Mit Bezug zu den Figuren 4A und 4B wird ein Ausführungsbeispiel für die Einstellung von Parameterwerten mittels eines Slider-Elements erläutert. Dabei wird insbesondere von dem oben mit Bezug zu den Figuren 1 und 2 erläuterten Ausführungsbeispiel der Vorrichtung ausgegangen. Die Ansteuerung erfolgt insbesondere mittels der Steuereinheit 3.

Die nachfolgenden Erläuterungen beziehen sich beispielhaft auf das Slider-Element 112, das bei dem Ausführungsbeispiel als Gebläse-Slider 112 der Erfassungseinheit 2 zum Einstellen eines Gebläses der Klimatisierungseinheit 4 zugeordnet ist. Selbstverständlich kann das Verfahren auch für andere Slider-Elemente 112, 113, 114 sowie zur Erfassung anderer Parameterwerte verwendet werden.

Auf der dem Nutzer zugewandten Oberfläche der Erfassungseinheit 2, wie etwa in Figur 2 dargestellt, ist im Bereich des Gebläse-Sliders 112 eine horizontale Linie angeordnet, an deren linkem Ende ein Gebläse-Symbol 112a für einen ausgeschalteten Zustand des Gebläses und an deren rechtem Ende ein Gebläse-Symbol 112b für einen maximal aktiven Zustand des Gebläse angeordnet ist.

Hinter der Oberfläche sind Lichtquellen angeordnet, bei dem Ausführungsbeispiel LEDs, durch die sowohl die Linie 112, als auch die Symbole 112a, 112b beleuchtbar sind. Bei dem Ausführungsbeispiel ist ferner die Linie 112 als Segmentanzeige beleuchtbar, das heißt, hinter hier sind Lichtquellen in einer Reihe nebeneinander so angeordnet, dass einzelne Bereiche der Linie 112 unabhängig voneinander mit verschiedenen Intensitäten beleuchtet werden können. Hierdurch wird beispielsweise die eingestellte Stufe des Gebläses gemäß dem oben mit Bezug zu den Figuren 3A bis 3C erläuterten Verfahren ausgegeben. Die Symbole 112a, 112b und die Linie 112 können dauerhaft sichtbar aufgedruckt oder mittels einer Black-Panel-Technik nur dann sichtbar gebildet sein, wenn sie von hinten beleuchtet werden.

In den Figuren 4A und 4B sind jeweils berührungsempfindliche Bereiche 149, 141a, 141b, 142a bis 142i durch gestrichelte Linien angedeutet. In diesen Bereichen erfassen die Sensorelemente Sa bis Sc eine Betätigung durch ein Betätigungsobjekts, wie oben bereits erläutert, oder die Erfassung kann auf andere Weise erfolgen. Bei einer Betätigung wird gemäß dem Ausführungsbeispiel die Oberfläche der Erfassungseinheit 2 in einem berührungsempfindlichen Bereich durch das Betätigungsobjekt berührt. Bei weiteren Ausführungsbeispielen kann statt einer Berührung auch erfasst werden, wenn sich das Betätigungsobjekt in einem bestimmten räumlichen Bereich oder an einer Position befindet, beispielsweise dicht über der Oberfläche der Erfassungseinheit 2.

Bei dem Ausführungsbeispiel wird eine Betätigung an einer bestimmten Position dadurch erfasst, dass die Sensorelemente Sa bis Sc in Abhängigkeit von der Position des Betätigungsobjekts unterschiedlich starke Signale detektieren. Beispielsweise hängt die Stärke eines von einem kapazitiven Sensoren erfassten Signals von dem Abstand eines in einen Erfassungsbereich eintretenden Betätigungsobjekts ab. Bei dem Ausführungsbeispiel berührt der Nutzer das Slider-Element 112 an einem beliebigen Punkt oder er verschiebt die Position seiner Bewegung entlang des Slider-Elements 112. In Abhängigkeit von der aktuellen Position werden somit durch die Sensorelemente Sa bis Sc verschiedene Signalstärken detektiert. Anhand dieser Signalstärken wird die Position bestimmt und es wird ein Parameterwert in Abhängigkeit von der bestimmten Position eingestellt.

Auf diese Weise können unterschiedliche räumliche Bereiche, insbesondere Flächenbereiche auf der Oberfläche der Erfassungseinheit 2, als voneinander getrennte Bereiche verwendet werden, um darin Betätigungen zu erfassen. Insbesondere können diese Betätigungen auch abhängig von dem jeweiligen Flächenbereich unterschiedlich ausgewertet werden. Beispielsweise kann ein Flächenbereich als Taster-Element mit einem bestimmten Ansprechverhalten, das heißt etwa mit bestimmten Schwellenwerten für Zeitintervalle zu Betätigung, oder als Slider-Element mit einem anderen Ansprechverhalten konfiguriert sein.

Das heißt, die Flächenbereiche, innerhalb derer Betätigungen erfasst werden können, können lediglich virtuell ausgebildet werden, statt für jeden beliebigen Bereich einen eigenen zu benötigen. Es kann ein zusammenhängender Bereich gebildet werden, innerhalb dessen die Position einer Betätigung oder eine Betätigungstrajektorie erfasst wird, oder es können einzelne Bereiche gebildet werden, bei denen eine Betätigung erfasst wird, wenn diese einer beliebigen Position innerhalb dieser einzelnen Bereiche zugeordnet wird.

Bei dem Ausführungsbeispiel ist ferner vorgesehen, dass die eingestellte Stufe durch eine Segmentanzeige, im Bereich des Slider-Elements 112 angezeigt wird. Dies erfolgt auf die oben mit Bezug zu den Figuren 3A bis 3C erläuterte Art. Bei einer Betätigung des Slider-Elements 112 an einer Position wird dieses an der entsprechenden Position beleuchtet und die entsprechende Stufe des Gebläses wird eingestellt. Allerdings wird bei dem Ausführungsbeispiel nicht nur detektiert, im Bereich welcher Stufe sich die Betätigungsposition aktuell befindet, sondern es wird auch eine Annäherung an umliegende Bereiche erfasst. Insbesondere wird erfasst, wenn sich das Betätigungsobjekt, etwa der Finger des Nutzers, in Richtung einer anderen Stufe bewegt und diese Annäherung wird auch angezeigt. Beispielsweise kann der Nutzer seinen Finger entlang des Slider-Elements 112 bewegen und sich dabei an einen Bereich annähern, der einer nächsten Stufe des Gebläses zugeordnet ist. Das in diesem Bereich angeordnete Beleuchtungselement wird mit zunehmender Intensität beleuchtet, je näher der Nutzer sich an den Bereich der nächsten Stufe annähert. Wenn der Nutzer den nächsten Bereich erreicht, wird dieser mit der normalen Anzeige-Intensität beleuchtet.

Im Unterschied zu bekannten berührungsempfindlichen Oberflächen wird der Parameterwert bei dem Ausführungsbeispiel des Verfahrens mittels weniger Sensoren, besonders flexibel und/oder mit einer höheren Auflösung erfasst. Während bekannte Verfahren zumindest ein Sensorelement für jede erfassbare Position vorsehen, werden bei dem erläuterten Verfahren weniger Sensoren auf besonders platzsparende, kosteneffiziente und einfacher Weise genutzt.

Es werden verschiedene Parameter der Betätigung erfasst und ausgewertet, etwa eine Startposition, bei welcher die Berührung beginnt, eine Endposition, bei der die Berührung endet, sowie eine Trajektorie, entlang derer sich das Betätigungsobjekt entlang der Oberfläche von der Start- zur Endposition bewegt. Alternativ oder zusätzlich kann eine Dauer der Berührung und/oder des Aufenthalts an einer bestimmten Position erfasst werden. Gegebenenfalls kann auch eine Richtung und/oder Geschwindigkeit einer Bewegung entlang der Oberfläche bestimmt und ausgewertet werden.

Es sind mehrere Betätigungsmöglichkeiten unterscheidbar, die insbesondere verschiedene Arten der Betätigung zum Eingeben oder Auswählen eines Parameterwerts bezeichnen und die nachfolgend auch als "*Usecases"* bezeichnet werden. Diese können beispielsweise für Taster- oder Slider-Elemente sowohl in berührungsempfindlichen Flächenbereichen als auch für mechanische Schalter verwendet werden.

Der Nutzer kann den berührungsempfindlichen Bereich durch "*Antippen*" betätigen, wobei zwischen dem Beginn und dem Ende der Berührung ein Zeitintervall *Δt* erfasst wird, dass kürzer als ein bestimmter Schwellenwert *t₀* ist: *Δt* < *t₀.* Der Schwellenwert *t₀* kann beispielsweise 400 ms oder 800 ms betragen. Der Zeitpunkt, bei dem ein Betätigungsereignis erfasst und beispielsweise ein Parameterwert verändert wird, ist hier typischerweise der Zeitpunkt, bei dem die Berührung gelöst wird. Alternativ kann ein Betätigungsereignis auch dann erfasst werden, wenn die Berührung beginnt, wobei in diesem Fall jede Berührung bereits ein Antipp-Ereignis auslöst. Typische Anwendungen für das Antippen sind etwa das An- und Ausschalten einer Funktion, das inkrementelle Verändern von Parameterwerten oder die direkte Auswahl eines Parameterwert durch Antippen einer Schaltfläche.

Der Nutzer kann ferner die Berührung an einer bestimmten Position oder in einem bestimmten Flächenbereich für ein längeres Zeitintervall *Δt* als einen Schwellenwert *t₁* halten: *Δt > t₁*. Der Schwellenwert *t₁* kann beispielsweise 400 ms oder 800 ms betragen. Eine solche Betätigung kann als "*Halten*"*,* "*Longpress*" oder "*Longpush*" bezeichnet werden. Ein entsprechendes Halte-Ereignis kann ausgelöst werden, sobald das gehaltene Zeitintervall *Δt* den Schwellenwert *t₁* überschreitet oder wenn die Berührung gelöst wird. Als weitere Bedingungen kann definiert sein, dass die Berührung an einer bestimmten Position oder in einem bestimmten Bereich gelöst werden muss, um einen Halte-Ereignis auszulösen; in diesem Fall kann der Nutzer das Auslösen verhindern, indem er das Betätigungsobjekt in einen anderen Bereich verschiebt, etwa auf ein anderes Taster-Element.

Ferner kann ein "*mehrfaches Halten*" dadurch durchgeführt werden, dass die Berührung eines ersten Flächenbereichs länger als ein Schwellenwert *t₁* dauert und anschließend in einen zweiten Flächenbereich übergeht, der dann ebenfalls länger als der Schwellenwert *t₁* berührt wird. Hierdurch können beispielsweise mehrere Taster-Elemente betätigt werden, ohne das Betätigungsobjekt abheben zu müssen. Dazu wird ein erstes Taster-Element mit einer "Halten"-Geste betätigt und anschließend rutscht der Nutzer mit dem Betätigungsobjekt, ohne die Berührung zu lösen, zu einem anderen Taster-Element weiter.

Bei einem "*dauerhaften Halten*" wird eine Betätigung für ein Zeitintervall *Δt* länger als ein Schwellenwert *t₀* erfasst und es wird für jedes Vielfache des Schwellenwerts *t₀* eine erneute Betätigung erfasst. Der Nutzer kann dabei eine mehrfache Betätigung dadurch auslösen, dass er die Betätigung für ein entsprechendes Vielfaches des Schwellenwerts *t₀* hält.

Ferner kann ein "*Wischen*" als Betätigung erfasst werden, etwa wenn das Betätigungsobjekt für ein Zeitintervall *Δt* kürzer als ein Schwellenwert *t₀* in einem Flächenbereich verweilt und anschließend einen benachbarten Flächenbereich betätigt. Die Betätigung kann dann beispielsweise für den benachbarten Flächenbereich beim Lösen der Berührung erfasst werden, wobei insbesondere berücksichtigt wird, ob der Nutzer den benachbarten Flächenbereich für ein Zeitintervall *Δt* kürzer als den Schwellenwert *t₀* berührt oder ob hier beispielsweise ein Halten durchgeführt wird.

Ferner kann ein "*Swipe*" als Betätigung erfasst werden, wobei sich die Position der Berührung von einem ersten zu einem zweiten Flächenbereich bewegt und dabei insbesondere weitere Flächenbereiche überquert werden. Dabei wird zudem die Geschwindigkeit berücksichtigt, mit der sich die Position verändert und es kann beispielsweise ein Parameterwert schneller verändert werden als bei einem Wischen. Ein "Swipe" kann insbesondere dann erfasst werden, wenn die Geschwindigkeit der Wisch-Geste einen Schwellenwert überschreitet.

Bei dem in Figur 4A gezeigten Fall ist der Gebläse-Slider als zusammenhängender aktiver Slider-Bereich 149 definiert, der sich über die gesamte Länge der Linie 112 sowie die angrenzenden Symbole 112a, 112b erstreckt. Innerhalb der Fläche 149 dieses aktiven Slider-Bereichs 149 können die Positionen von Berührungen und Betätigungen erfasst werden. Wenn sich das Betätigungsobjekt entlang der Längsausdehnung des Gebläse-Sliders 112 bewegt, wird die Position der Berührung, insbesondere während einer Wischgeste, kontinuierlich erfasst und die eingestellte Stufe des Gebläses folgt dieser Position. Beispielsweise ist eine niedrigste Stufe dem linken Bereich des Gebläse-Sliders 112 oder dem linken Gebläse-Symbol 112a zugeordnet, während eine höchste Stufe dem rechten Bereich des Gebläse-Sliders 112 oder dem rechten Gebläse-Symbol 112b zugeordnet ist. Dazwischen verteilen sich über die Längserstreckung des Gebläse-Sliders 112 Bereiche gleicher Größe, denen jeweils eine dazwischen liegende Stufe zugeordnet ist.

Bei dem Beispiel wird eine Stufe eingestellt, wenn das Betätigungsobjekt eine Position erreicht, die dieser Stufe zugeordnet ist. Bei weiteren Ausführungsbeispielen erfolgt das Einstellen der Stufe erst, wenn die Berührung gelöst wird, wobei dann diejenige Stufe eingestellt wird, die der Position beim Lösen der Berührung zugeordnet ist.

Bei dem in Figur 4B gezeigten Fall sind dagegen einzelne berührungsempfindliche Flächenbereiche 142a bis 142i ausgebildet. Diese werden durch Antippen betätigt, sodass der Nutzer die Stufen des Gebläse direkt durch Auswahl eines berührungsempfindlichen Flächenbereichs 142a bis 142i auswählen kann.

Dabei sind zusätzlich die beiden äußersten linken 142a, 142b und rechten 142h, 142i berührungsempfindlichen Flächenbereiche zu vergrößerten Betätigungsbereichen 141a, 141b zusammengefasst. Durch Antippen in einem dieser vergrößerten Betätigungsbereiche 141a, 141b kann der Nutzer die Stufe des Gebläse inkrementell erhöhen oder erniedrigen. Durch dauerhaftes Halten in einem der vergrößerten Betätigungsbereiche 141a, 141b wird die Stufe schrittweise erhöht oder erniedrigt, je nach dem Zeitintervall, während dessen die Berührung gehalten wird.

Bei dem Ausführungsbeispiel werden durch die Vergrößerung der Betätigungsbereiche 141a, 141b die Möglichkeiten zur direkten Anwahl einer Stufe des Gebläse insofern beschränkt, als die niedrigste und höchste Stufe nicht direkt auswählbar ist. Stattdessen werden diese Stufen lediglich dadurch erreicht, dass ausgehend von der nächsten benachbarten Stufe der entsprechende vergrößerte Betätigungsbereich 141a, 141b erneut angetippten oder dauerhaft erhalten wird.

Die in den Figuren 4A und 4B gezeigten Fälle sind bei dem Ausführungsbeispiel nicht als statische Konfigurationen der Erfassungseinheit 2 zu verstehen. Vielmehr schaltet die Erfassungseinheit 2 dynamisch zwischen den beiden Konfigurationen um und zwar in Abhängigkeit von der Art der erfassten Betätigung, das heißt dem erfassten *Usecase.* Das heißt, wenn der Nutzer eine Wischgeste durchführt, wird die Betätigung so interpretiert, wie oben mit Bezug zu Figur 4A erläutert. Führt der Nutzer dagegen eine Antipp- oder eine dauerhafte Haltegeste durch, so erfolgt die Auswertung dieser Geste wie bei der mit Bezug zu Figur 4B erläuterten Konfiguration.

Bei weiteren Ausführungsbeispielen können die genannten Konfigurationen auf andere Weise kombiniert oder ausgebildet sein.

Bei dem Ausführungsbeispiel ist ferner vorgesehen, dass die Taster-Elemente 108 bis 111, die benachbart zu Slider-Elementen 112, 113, 140 angeordnet sind, für das Erfassen einer Betätigung gesperrt werden, nachdem eine Wischgeste im Bereich eines der Slider-Elemente 112, 113, 114 erfasst wurde. Dadurch wird vermieden, dass der Nutzer versehentlich eines der Taster-Elemente 108 bis 111 betätigt, wenn er bei einer Wischgeste eine Bewegung des Betätigungsobjekts über den Bereich eines Slider-Elements 112, 113, 114 hinaus fortsetzt.

Die Sperrung der benachbarten Taster-Elemente 108 bis 111 oder weiterer berührungsempfindliche Flächen oder Schaltelemente wird für ein bestimmtes Sperr-Zeitintervall durchgeführt. Dieses Sperr-Zeitintervall beginnt insbesondere zu dem Zeitpunkt, bei dem die Berührung des Slider-Elements 112, 113, 114 beendet wird, und es kann insbesondere dynamisch bestimmt werden, etwa anhand der Geschwindigkeit der Wischgeste und/oder einer Fahrgeschwindigkeit des Fahrzeugs 1.

Bei weiteren Ausführungsbeispielen wird ein Abstand von einem Slider-Element 112, 113, 114 definiert, innerhalb dessen in dem Sperr-Zeitintervall keine Betätigung erfasst werden. Auch dieser Abstand kann dynamisch bestimmt werden, etwa anhand der Geschwindigkeit der Wischgeste, einer Längserstreckung des Slider-Elements 112, 113, 114 und/oder anhand der Fahrgeschwindigkeit des Fahrzeugs 1. Anhand des Abstands kann insbesondere ein Flächenbereich definiert werden, der eine Längserstreckung des Slider-Elements 112, 113, 114 fortsetzt; beispielsweise wird dann eine Fläche ober- oder unterhalb eines horizontal verlaufenden Slider-Elements 112, 113, 114 nicht gesperrt, während seitlich angrenzende Flächenbereiche während des Sperr-Zeitintervalls gesperrt sind.

Bei einem weiteren Ausführungsbeispiel erfolgt die Sperrung der benachbarten Taster-Elemente 108 bis 111 nur dann, wenn erfasst wurde, dass eine Wischgeste zumindest bis zu einem seitlichen Ende des Slider-Elements 112, 113, 114 oder darüber hinaus durchgeführt wurde. Bei weiteren Ausführungsbeispielen kann die Sperrung bestimmter Flächenbereiche der Erfassungseinheit 2 durch andere Ereignisse als eine Wischgeste ausgelöst werden, beispielsweise durch jegliche Betätigung in einem bestimmten Flächenbereich.

Bei einem weiteren Ausführungsbeispiel betätigt der Nutzer erst eine erste Taste, ändert dann seine Auswahl und rutscht zu einer anderen Taste. In diesem Fall kann vorgesehen sein, dass die Betätigung erst erfasst wird, wenn der Nutzer die Berührung löst. Erst dann wird das Sperr-Zeitintervall ausgelöst. Das heißt, der Nutzer kann in diesem Fall, ohne die Berührung zu lösen, von einer ersten zu einer zweiten Taste verrutschen und beim Abheben des Fingers die zweite Taste betätigen. Erst dann beginnt das Sperr-Zeitintervall und es kann keine andere Taste betätigt werden.

Bei einem Ausführungsbeispiel wird eine akustische Rückmeldung erzeugt, wenn eine Eingabegeste oder ein Gestentyp erkannt wird. Insbesondere wird die akustische Rückmeldung erzeugt, wenn ein Steuersignal anhand einer erfassten Eingabe erzeugt wird. Der Nutzer kann dadurch erkennen, ob seine Eingabe angenommen wurde. Die akustische Rückmeldung kann alternativ oder zusätzlich auch dann erzeugt werden, wenn der Parameterwert verändert wird. Sie wird auf an sich bekannte Weise erzeugt, wobei unterschiedliche Rückmeldungen ausgegeben werden können, etwa um einen erkannten Gestentyp, einen eingestellten Parameterwert oder andere Einflussgrößen auszugeben. Die akustische Rückmeldung kann dazu auch dynamisch gebildet werden, etwa indem eine Tonhöhe in Abhängigkeit von dem eingestellten Parameterwert gebildet wird.

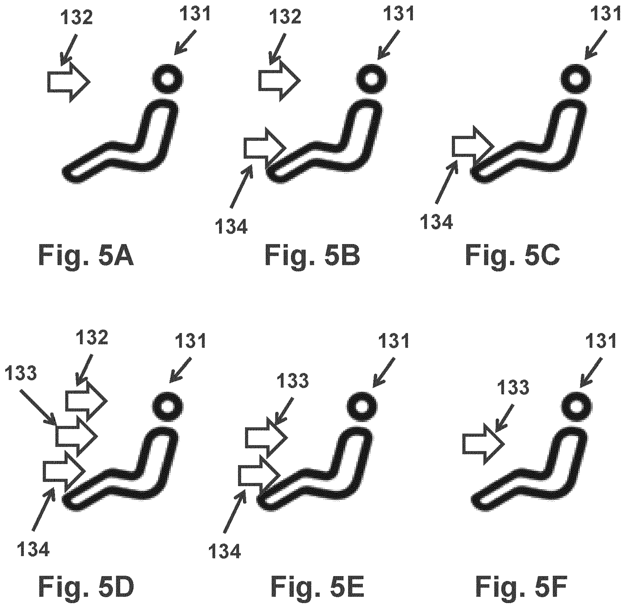

Mit Bezug zu den Figuren 5A bis 5F wird ein Ausführungsbeispiel für die Einstellung einer Luftverteilung durch ein Gebläse erläutert. Dabei wird von den oben erläuterten Ausführungsbeispielen ausgegangen.

Bei dem Ausführungsbeispiel umfasst die in Figur 2 gezeigte Oberfläche der Erfassungseinheit 2 ein Taster-Element 104, mit dem eine Verteilung der durch ein Gebläse der Klimatisierungseinheit 4 in den Innenraum des Fahrzeugs 1 geleiteten Luft eingestellt werden kann. Im Bereich dieses Taster-Elements 104 wird ferner eine Anzeige der eingestellten Verteilung ausgegeben.

In den Figuren 5A bis 5F wird die Verteilung durch Pfeile 132, 133, 134 ausgegeben, die in unterschiedlicher Höhe relativ zu einer Passagierdarstellung 131 angeordnet sind. Die Pfeile 132, 133, 134 werden durch unabhängig voneinander beleuchtbare Leuchtflächen gebildet, während die Passagierdarstellung 131 auf die Oberfläche aufgedruckt und daher dauerhaft sichtbar ist. Bei dem Ausführungsbeispiel sind die Pfeile 132, 133, 134 ungefähr in Höhe eines Kopf-, Rumpf- beziehungsweise Fußbereichs der Passagierdarstellung 131 angeordnet.

Bei dem Ausführungsbeispiel wird das Taster-Element 104 als "Toggle"-Schalter verwendet. Das heißt, es ist eine feste Reihenfolge unterschiedlicher Einstellungen vorgegeben und bei jeder Betätigung des Taster-Elements 104 wird die der Reihenfolge nach folgende Einstellung eingestellt. Beim Erreichen der letzten Einstellung erfolgt ein Sprung zur ersten Einstellung der Reihenfolge, insbesondere nach Art einer periodischen Randbedingung. Bei weiteren Ausführungsbeispielen kann die Reihenfolge beim Erreichen der letzten Einstellung umgekehrt fortgesetzt werden, insbesondere nach Art einer reflektierenden Randbedingung.

Bei dem in Figur 5A gezeigten Fall wird Luft im oberen Bereich des Fahrzeuginnenraums eingeleitet. Bei dem in Figur 5B gezeigten Fall erfolgt zusätzlich eine Einleitung im Fußbereich des Innenraums. Bei dem in Figur 5C gezeigten Fall strömt die Luft lediglich in den Fußbereich. Bei dem Fall der Figur 5D strömt die Luft in den Kopf-, Rumpf- und Fußbereich des Fahrzeuginnenraums, während sie bei dem Fall der Figur 5E in den Rumpf- und Fußbereich eingeleitet wird. Bei dem Fall der Figur 5F schließlich wird die Luft so eingeleitet, dass sie etwa im Rumpfbereich auf einen Passagier im Fahrzeug 1 trifft.

Bei weiteren Ausführungsbeispielen können die Luftverteilungen in einer anderen Reihenfolge geordnet oder auf andere Weise gebildet sein.

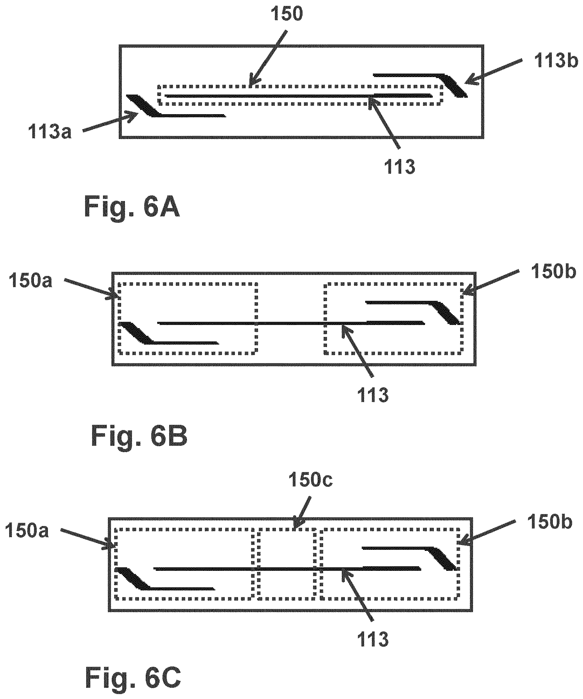

Mit Bezug zu den Figuren 6A bis 6C wird ein weiteres Ausführungsbeispiel für die Einstellung eines Parameterwerts mittels eines Slider-Elements erläutert. Dabei wird von den oben erläuterten Ausführungsbeispielen ausgegangen.

Der Temperatur-Slider 113 umfasst eine horizontale gerade Linie 113, an deren Enden Temperatur-Symbole 113a, 113b angeordnet sind. Diese sind bei dem Ausführungsbeispiel auf der linken Seite blau und auf der rechten Seite rot gefärbt, um niedrige beziehungsweise hohe Temperaturen zu symbolisieren. Aktive Slider-Bereiche 150, 150a, 150b, 150c werden, analog zu den Figuren 2, 4A und 4B, durch gestrichelte Linien angedeutet.

Bei dem in Figur 6A gezeigten Fall erstreckt sich der aktive Slider-Bereich 150 über die gesamte Länge der Linie 113 sowie einen schmalen Bereich in ihrer Umgebung. Der Nutzer kann den Wert des Temperaturparameters für die Klimatisierungseinheit 4 durch eine Wischgeste entlang der Linie 113 innerhalb des aktiven Slider-Bereichs 150 verändern.

Dabei ist bei dem Ausführungsbeispiel vorgesehen, dass die eingestellte Temperatur erhöht wird, wenn eine nach rechts gerichtete Wischgeste erfasst wird. Dagegen wird die eingestellte Temperatur erniedrigt, wenn eine nach links gerichtete Wischgeste erfasst wird.

Die Differenz, um welche die Temperatur verändert wird, hängt bei dem Ausführungsbeispiel davon ab, entlang welcher Betätigungstrajektorie die Wischgeste ausgeführt wird. Die Temperatur kann bei maximaler Ausnutzung der Sliderlänge, das heißt bei einer Wischgeste über die gesamte Breite der Linie 113, um ein bestimmtes Intervall, hier bis zu 4°C, erhöht oder erniedrigt werden. Bei einer Wischgeste über eine geringere Strecke, erfolgt eine anteilsmäßig geringere Veränderung des Parameters der Temperatur. Das heißt, bei einer Wischgeste repräsentiert das Slider-Element 113 eine relative Skala zur relativen Veränderung der eingestellten Temperatur.

Bei einem weiteren Ausführungsbeispiel ist ferner eine *Swipe*-Geste vorgesehen, bei welcher für die Wischgeste eine Geschwindigkeit erfasst wird, die einen bestimmten Schwellenwert überschreitet. Wird eine solche *Swipe-*Geste erfasst, so kann der Temperaturparameter schneller verändert werden, etwa durch Sprung zu einer maximalen oder minimalen Temperatur oder durch eine Veränderung um ein größeres Intervall, etwa das doppelte Intervall, wie es für eine Wischgeste vorgesehen ist, das heißt 8°C.

Bei dem in Figur 6B gezeigten Fall sind aktive Slider-Bereiche 150a, 150b ausgebildet, die das linke beziehungsweise rechte Temperatur-Symbol 113a, 113b sowie einen linken beziehungsweise rechten Teil der Linie 113 einschließen. Die Bedienung erfolgt bei diesem Ausführungsbeispiel ähnlich wie bereits oben mit Bezug zu Figur 4B und die vergrößerten Betätigungsbereiche 141a, 141b beschrieben: Die aktiven Slider-Bereich 150a, 150b können hier durch Antippen, Halten oder dauerhaftes Halten betätigt werden, wobei hierdurch der eingestellte Temperaturparameter schrittweise erhöht wird.

Zum Beispiel kann die Temperatur bei jedem Antippen im linken Bereich 150a um 0,5°C erniedrigt und bei jedem Antippen im rechten Bereich 150b um 0,5°C erhöht werden.

Bei weiteren Ausführungsbeispielen erfolgt beim Halten und insbesondere beim dauerhaften Halten über eine längere Zeitdauer die Erhöhung in mehreren Schritten nacheinander, wobei die Größe der Schritte beispielsweise in Abhängigkeit von der Dauer des Haltens bestimmt werden kann, sodass beispielsweise nach dauerhaftem Halten für eine bestimmte Zeit der Parameter in Schritten von 1°C verändert wird, um schneller Änderungen zu ermöglichen.

Bei dem in Figur 6C gezeigten Fall sind ähnliche aktive Slider-Bereiche 150a, 150b wie bei dem in Figur 6B gezeigten Fall ausgebildet. Zusätzlich ist nun allerdings ein mittlerer aktiver Slider-Bereich 150c vorgesehen, der zwischen den beiden seitlichen aktiven Slider-Bereichen 150a, 150b angeordnet ist. Bei dem Ausführungsbeispiel erstreckt sich der mittlere aktive Slider-Bereich 150c über etwa 20 % der Länge der Linie 113, während die beiden seitlichen aktiven Slider-Bereiche 150a, 150b rechts und links davon jeweils etwa 40 % der Länge einnehmen. Bei dem hier gezeigten Fall kann der Nutzer direkt einen minimalen, maximalen oder mittleren Parameterwert einstellen.

Bei dem Ausführungsbeispiel ist vorgesehen, dass ein Halten, bei dem eine Berührung in einem der aktiven Slider-Bereiche 150a, 150b, 150c länger als ein bestimmter Schwellenwert gehalten wird, als eine Betätigung erfasst und als Direktwahl ausgewertet wird. Bei dem Ausführungsbeispiel wird direkt ein minimaler Parameterwert "*LO*" für die Temperatur eingestellt, wenn die Halte-Geste in dem linken aktiven Slider-Bereich 150a erfasst wurde. Analog dazu wird ein maximaler Parameterwert "*HI*" bei einer Halte-Geste in dem rechten aktiven Slider-Bereich 150b eingestellt sowie ein vorgegebener Parameterwert von 22°C bei einer Halte-Geste in dem mittleren aktiven Slider-Bereich 150c.

Bei weiteren Ausführungsbeispielen können andere Parameterwerte direkt ausgewählt werden. Ferner können unterschiedliche Bereiche als aktive Slider-Bereiche 150a, 150b, 150c vorgesehen sein, beispielsweise mit unterschiedlicher Anzahl oder mit verschiedenen Abmessungen.

Bei weiteren Ausführungsbeispielen können andere Betätigungen für die Direktwahl vorgesehen sein, beispielsweise ein Antippen eines aktiven Slider-Bereichs 150, 150a, 150b, 150c, insbesondere mit mehreren Fingern gleichzeitig. Ferner können weitere Gesten vorgesehen sein, zum Beispiel eine gleichzeitige Betätigung der äußeren aktiven Slider-Bereiche 150a, 150b oder eine Betätigung eines Slider-Bereichs 150, 150a, 150b, 150c mit mehreren Fingern. Bestimmte Gesten können ferner zum Aufruf bestimmter Funktionen oder zum Einstellen bestimmter Parameter verwendet werden. Beispielsweise kann ein "*SYNC*"-Modus der Klimatisierungseinheit 4 des Fahrzeugs 1 aktiviert werden, wobei gleiche Einstellungen für verschiedene Bereiche des Innenraums des Fahrzeugs 1 eingestellt werden, beispielsweise für den Fahrer- und Beifahrerbereich. Ferner können unterschiedliche Funktionen mittels bestimmter *Usecases* durch das gleiche Element an- oder ausgeschaltet werden.

Die in den Figuren 6A bis 6C gezeigten Konfigurationen und Anordnungen aktiver Slider-Bereiche 150, 150a, 150b, 150c können als statische Konfigurationen der Erfassungseinheit 2 ausgebildet sein. Allerdings ist bei dem Ausführungsbeispiel vorgesehen, dass die Erfassungseinheit 2 dynamisch zwischen den Konfigurationen wechselt, je nachdem, wie der Temperatur-Slider 113 bedient wurde, das heißt, welcher *Usecase* erfasst wurde. Wenn eine Betätigung mittels einer Wisch- oder Swipe-Geste erfasst wird, so wird diese entsprechend einer Eingabe bei der in Figur 6A gezeigten Konfiguration mit einem schmalen aktiven Slider-Bereich 150 ausgewertet. Wird dagegen eine Antipp-, Halte- oder eine dauerhafte Haltegeste erfasst, so kann automatisch zur Erfassung gemäß einer Konfiguration der Figur 6B oder 6C umgeschaltet werden, insbesondere um eine Direktwahl zu ermöglichen.

Bei weiteren Ausführungsbeispielen können die genannten Konfigurationen auf andere Weise kombiniert oder ausgebildet sein.

Bei weiteren Ausführungsbeispielen umfasst das Fahrzeug 1 alternativ oder zusätzlich eine andere Einrichtung, für die mittels der Erfassungseinheit 2 ein Parameterwert erfasst wird. Derartige andere Einrichtungen können beispielsweise eine Medienwiedergabe oder ein Navigationssystem des Fahrzeugs 1 betreffen. Die Eingaben werden dann analog zu den oben erläuterten Ausführungsbeispielen der Erfassungseinheit 2 sowie der Verfahren zum Eingeben eines Parameterwerts erfasst.

Die oben erläuterten Möglichkeiten zur Eingabe von Parameterwerten können prinzipiell beliebig miteinander kombiniert und angepasst werden. Ferner kann die Erfassungseinheit 2 unterschiedliche Bedienelemente umfassen, die zudem unterschiedlich angeordnet sein können. Beispielsweise können Slider-Elemente 112, 113, 114 statt waagerecht auch senkrecht oder in andere Raumrichtungen verlaufen.

Die Ansteuerung erfolgt bei den Ausführungsbeispielen durch die Steuereinheit 3. Es können jedoch verschiedene Systemkonfigurationen vorgesehen sein, etwa mit einem Steuergerät der Erfassungseinheit 2, welche die Ansteuerung übernimmt und/oder gegebenenfalls vorliegende Eingaben auswertet, vorverarbeitet und ein Steuersignal erzeugt, etwa um den Parameterwert einzustellen.

### Bezugszeichenliste

1 Fahrzeug
2 Erfassungseinheit
3 Steuereinheit
4 Klimatisierungseinheit
La, Lb, Lc, Ld, Le Leuchtelement
LED1, LED2, LEDS, LED4, LED5, LED6, LED7 Leuchtfläche
Sa, Sb, Sc Sensorelement
101, 102, 103, 104, 105, 106, 107 Taster-Element
108 Taster-Element "AUTO"
109 Taster-Element "A/C"
110 Taster-Element "MENU"
111 Taster-Element "OFF"
112 Slider-Element; Gebläse-Slider; Linie
112a Gebläse-Symbol (links)
112b Gebläse-Symbol (rechts)
113 Slider-Element; Temperatur-Slider (links); Linie
113a Temperatur-Symbol (links)
113b Temperatur-Symbol (rechts)
114 Slider-Element; Temperatur-Slider (rechts); Linie
115, 116 Segmentanzeige
131 Passagierdarstellung
132 Pfeil (oben)
133 Pfeil (Mitte)
134 Pfeil (unten)
141a vergrößerter Betätigungsbereich (links); Flächenbereich
141b vergrößerter Betätigungsbereich (rechts); Flächenbereich
142a bis 142i aktiver Betätigungsbereich; Flächenbereich
149 aktiver Slider-Bereich; Flächenbereich
150 aktiver Slider-Bereich; Flächenbereich
150a aktiver Slider-Bereich (links); Flächenbereich
150b aktiver Slider-Bereich (rechts); Flächenbereich
150c aktiver Slider-Bereich (Mitte); Flächenbereich

## Patentansprüche

1. Vorrichtung zur Ausgabe eines Parameterwerts in einem Fahrzeug (1), umfassend
zumindest zwei Leuchtelemente (La bis Le), nämlich ein erstes und ein zweites Leuchtelement (La bis Le); wobei
für jedes der zumindest zwei Leuchtelemente (La bis Le) zumindest ein Grund-Aktivierungszustand und ein Anzeige-Aktivierungszustand aktivierbar ist; wobei
die Leuchtelemente (La bis Le) bei dem Grund-Aktivierungszustand Licht einer Grundintensität und bei dem Anzeige-Aktivierungszustand Licht einer Anzeige-Intensität emittieren, wobei die Anzeige-Intensität höher ist als die Grundintensität; und
eine Steuereinheit (3), die dazu eingerichtet ist, für die zumindest zwei Leuchtelemente (La bis Le) entweder den Grund-Aktivierungszustand oder den Anzeige-Aktivierungszustand so zu aktivieren, dass der Parameterwert ausgegeben wird,
**dadurch gekennzeichnet, dass**
die Steuereinheit (3) dazu eingerichtet ist, die Grundintensität in Abhängigkeit von der Anzeige-Intensität zu wählen.

2. Vorrichtung gemäß Anspruch 1,
**dadurch gekennzeichnet, dass**
die Steuereinheit (3) dazu eingerichtet ist, den Anzeige-Aktivierungszustand für umso mehr Leuchtelemente (La bis Le) zu aktivieren, je höher der Parameterwert ist, und für die verbleibenden Leuchtelemente (La bis Le) den Grund-Aktivierungszustand zu aktivieren.

3. Vorrichtung gemäß Anspruch 1 oder 2,
**dadurch gekennzeichnet, dass**
die Leuchtelemente (La bis Le) aneinander angrenzend angeordnet sind.

4. Vorrichtung gemäß einem der vorhergehenden Ansprüche,
**dadurch gekennzeichnet, dass**
die Vorrichtung einen Tagmodus und einen Nachtmodus aufweist, wobei die Anzeige-Intensität im Tagmodus höher ist als im Nachtmodus.

5. Vorrichtung gemäß einem der vorhergehenden Ansprüche,
**dadurch gekennzeichnet, dass**
jedes der Leuchtelemente (La bis Le) ferner einen Dunkelzustand aufweist, bei dem es kein Licht emittiert.

6. Vorrichtung gemäß Anspruch 5,
**dadurch gekennzeichnet, dass**
die Vorrichtung ferner eine Abdeckschicht aufweist, die so gebildet ist, dass die Leuchtelemente (La bis Le) im Dunkelzustand für einen Betrachter der Vorrichtung nicht sichtbar sind.

7. Vorrichtung gemäß einem der vorhergehenden Ansprüche,
**dadurch gekennzeichnet, dass**
die Vorrichtung ferner eine Erfassungseinheit (2) umfasst, durch die mittels einer berührungsempfindlichen Oberfläche im Bereich der Leuchtelemente (La bis Le) der Parameterwert erfassbar ist.

8. Vorrichtung gemäß Anspruch 7,
**dadurch gekennzeichnet, dass**
die Vorrichtung im Bereich der berührungsempfindlichen Oberfläche eine Oberflächenstrukturierung, insbesondere eine Vertiefung oder Erhöhung, aufweist.

9. Verfahren zur Ausgabe eines Parameterwerts in einem Fahrzeug (1), bei dem
für zumindest zwei Leuchtelemente (La bis Le) entweder ein Grund-Aktivierungszustand oder ein Anzeige-Aktivierungszustand so aktiviert wird, dass der Parameterwert ausgegeben wird; wobei
die Leuchtelemente (La bis Le) bei dem Grund-Aktivierungszustand Licht einer Grundintensität und bei dem Anzeige-Aktivierungszustand Licht einer Anzeige-Intensität emittieren, wobei die Anzeige-Intensität höher ist als die Grundintensität,
**dadurch gekennzeichnet, dass**
die Grundintensität in Abhängigkeit von der Anzeige-Intensität gewählt wird.

## Claims

1. Apparatus for outputting a parameter value in a vehicle (1), comprising
at least two light-emitting elements (La to Le), specifically a first and a second light-emitting element (La to Le); wherein
at least one basic activation state and one display activation state is activable for each of the at least two light-emitting elements (La to Le); wherein
the light-emitting elements (La to Le) in the basic activation state emit light of a basic intensity and in the display activation state emit light of a display intensity, with the display intensity being higher than the basic intensity; and
a control unit (3), which is configured to activate either the basic activation state or the display activation state for the at least two light-emitting elements (La to Le) such that the parameter value is output,
**characterized in that**
the control unit (3) is configured to select the basic intensity in dependence on the display intensity.

2. Apparatus according to Claim 1,
**characterized in that**
the control unit (3) is configured to activate the display activation state for more light-emitting elements (La to Le) if the parameter value is higher and to activate the basic activation state for the remaining light-emitting elements (La to Le).

3. Apparatus according to Claim 1 or 2,
**characterized in that**
the light-emitting elements (La to Le) are arranged such that they adjoin one another.

4. Apparatus according to any of the preceding claims,
**characterized in that**
the apparatus has a day mode and a night mode, wherein the display intensity is higher in the day mode than in the night mode.

5. Apparatus according to any of the preceding claims,
**characterized in that**
each of the light-emitting elements (La to Le) furthermore has a dark state during which it does not emit any light.

6. Apparatus according to Claim 5,
**characterized in that**
the apparatus furthermore has a cover layer which is formed such that the light-emitting elements (La to Le) are not visible to a viewer of the apparatus in the dark state.

7. Apparatus according to any of the preceding claims,
**characterized in that**
the apparatus furthermore comprises a capturing unit (2), which may be used to capture the parameter value by means of a touch-sensitive surface in the region of the light-emitting elements (La to Le).

8. Apparatus according to Claim 7,
**characterized in that**
the apparatus has surface structuring, in particular an indentation or elevation, in the region of the touch-sensitive surface.

9. Method for outputting a parameter value in a vehicle (1), wherein
a basic activation state or a display activation state is activated for at least two light-emitting elements (La to Le) such that the parameter value is output; wherein the light-emitting elements (La to Le) in the basic activation state emit light of a basic intensity and in the display activation state emit light of a display intensity, with the display intensity being higher than the basic intensity,
**characterized in that**
the basic intensity is selected in dependence on the display intensity.

## Revendications

1. Dispositif de délivrance d'une valeur de paramètre dans un véhicule (1), ledit dispositif comprenant
au moins deux éléments lumineux (La à Le), à savoir un premier et un deuxième élément lumineux (La à Le) ;
au moins un état d'activation de base et un état d'activation d'affichage pouvant être activés pour chacun des au moins deux éléments lumineux (La à Le) ;
les éléments lumineux (La à Le) émettant une lumière ayant une intensité de base dans l'état d'activation de base et une lumière ayant une intensité d'affichage dans l'état d'activation d'affichage, l'intensité d'affichage étant supérieure à l'intensité de base ; et
une unité de commande (3) qui est conçue pour activer soit l'état d'activation de base, soit l'état d'activation d'affichage pour les au moins deux éléments lumineux (La à Le) de manière à délivrer la valeur de paramètre,
**caractérisé en ce que**
l'unité de commande (3) est conçue pour sélectionner l'intensité de base en fonction de l'intensité d'affichage.

2. Dispositif selon la revendication 1,
**caractérisé en ce que**
l'unité de commande (3) est conçue pour activer l'état d'activation d'affichage pour des éléments lumineux (La à Le) d'autant plus nombreux que la valeur de paramètre est élevée, et pour activer l'état d'activation de base pour les éléments lumineux restants (La à Le).

3. Dispositif selon la revendication 1 ou 2,
**caractérisé en ce que**
les éléments lumineux (La à Le) sont disposés de manière adjacents les uns aux autres.

4. Dispositif selon l'une des revendications précédentes,
**caractérisé en ce que**
le dispositif comporte un mode jour et un mode nuit, l'intensité d'affichage étant plus élevée en mode jour qu'en mode nuit.

5. Dispositif selon l'une des revendications précédentes,
**caractérisé en ce que**
chacun des éléments lumineux (La à Le) comporte en outre un état sombre dans lequel aucune lumière n'est émise.

6. Dispositif selon la revendication 5,
**caractérisé en ce que**
le dispositif comporte en outre une couche de recouvrement qui est formée de manière que les éléments lumineux (La à Le) ne soient pas visibles dans l'état sombre pour un observateur du dispositif.

7. Dispositif selon l'une des revendications précédentes,
**caractérisé en ce que**
le dispositif comprend en outre une unité de détection (2) permettant de détecter la valeur de paramètre au moyen d'une surface tactile dans la zone des éléments lumineux (La à Le).

8. Dispositif selon la revendication 7,
**caractérisé en ce que**
le dispositif comporte une structure de surface, notamment une dépression ou une élévation, dans la zone de la surface tactile.

9. Procédé de délivrance d'une valeur de paramètre dans un véhicule (1), procédé dans lequel soit un état d'activation de base soit un état d'activation d'affichage est activé pour au moins deux éléments lumineux (La à Le) de façon à délivrer la valeur de paramètre ;
les éléments lumineux (La à Le) émettant une lumière ayant une intensité de base dans l'état d'activation de base et une lumière ayant une intensité d'affichage dans l'état d'activation d'affichage, l'intensité d'affichage étant supérieure à l'intensité de base,
**caractérisé en ce que**
l'intensité de base est sélectionnée en fonction de l'intensité d'affichage.
